# EUROPÄISCHE PATENTSCHRIFT

(11) **EP 2 248 196 B1**
(45) Veröffentlichungstag und Bekanntmachung des Hinweises auf die Patenterteilung: **24.08.2011**
(21) Anmeldenummer: 09715746.5
(22) Anmeldetag: 12.02.2009
(51) Int. Cl.: H01L 35/30, F24D 17/00

(54) **THERMOGENERATOR**
THERMOGENERATOR
THERMOGENERATEUR

(30) Priorität: 29.02.2008 DE 102008011984
(43) Veröffentlichungstag der Anmeldung: 10.11.2010
(73) Patentinhaber: O-Flexx Technologies Gmbh, 47228 Duisburg (DE)
(72) Erfinder: BISGES, Michael, 93161 Sinzing (DE)
(74) Vertreter: Kohlmann, Kai
(86) Internationale Anmeldenummer: PCT/EP2009/051625
(87) Internationale Veröffentlichungsnummer: WO 2009/106431

(56) Entgegenhaltungen:
- WO-A1-80/01438
- DE-A1- 19 537 121
- DE-A1-102006 023 616
- GB-A- 2 172 394
- US-A1- 2003 196 652

## Beschreibung

Die Erfindung betrifft einen Thermogenerator mit mehreren elektrisch miteinander verbundenen Thermopaaren, die zwischen einer einen einfließenden Wärmestrom aufnehmenden heißen Seite und einer davon im Abstand angeordneten kalten Seite angeordnet sind.

Ein als Thermogenerator betriebenes Thermoelement liefert nach dem Seebeck-Effekt elektrische Spannung. Meist wird eine größere Anzahl von Thermopaaren zu einem Thermoelement zusammengeschaltet. Der Thermogenerator kann eines oder mehrere Thermoelemente umfassen, die elektrisch hintereinander und/oder parallel geschaltet sind. Die in den Thermoelementen genutzte Thermospannung ist temperaturabhängig und bewegt sich in einem Bereich von wenigen Mikrovolt. Es haben sich einige Legierungen durch ihre Eigenschaften bei bestimmten Temperaturen als Thermopaare durchgesetzt und sich somit eine Palette von Thermomaterialkombinationen (Thermopaare) über einen Temperaturbereich von -270°C bis 2600°C gebildet. Diese Palette wurde in Normen erfasst und definiert. Die derzeit gültige internationale Norm für Thermoelemente ist die IEC 584-1, das Pendant im deutschsprachigen Raum die DIN EN 60584 Teil 1. Diese Norm definiert 10 verschiedene Thermomaterialkombination in ihren Eigenschaften.

| Typ/Kennbuchstabe | Legierung |
|---|---|
| K | Nickel-Chrom / Nickel-Aluminium |
| T | Kupfer / Kupfer-Nickel |
| J | Eisen / Kupfer-Nickel |
| N | Nickel-Chrom-Silizium / Nickel-Silizium |
| E | Nickel-Chrom / Kupfer-Nickel |
| R | Platin-13%Rhodium / Platin |
| S | Platin-10%Rhodium / Platin |
| B | Platin-30%Rhodium / Platin |
| | |

Eine weitere in Deutschland noch angewendete Norm ist die DIN 43710, welche die Thermotypen U und L definiert. Diese Norm ist aber nicht mehr gültig.

| | |
|---|---|
| U | Kupfer / Kupfer-Nickel |
| L | Eisen / Kupfer-Nickel |

Neben den genormten Thermopaaren gibt es noch andere Kombination mit speziellen Eigenschaften. Ein Beispiel ist die Wolfram/Wolfram-Rhenium Kombination mit möglichen Temperaturbereichen bis 2600 °C.

Als leitfähige Materialien für Thermopaare von Thermoelementen kommen insbesondere auch p- und n- dotierte Halbleitermaterialen, meist Wismut-Tellurit, Bi₂Te₃ in Betracht. Außerdem kommen die in den nachfolgenden Tabellen 1.1. und 1.2 genannten p- und n-dotierten Verbindungen in Betracht:

**Tabelle 1.1: Die p-Typ Verbindungen mit den besten thermoelektrischen Eigenschaften.**

| T [K] | Verbindung p-Typ | Z [1/K] |
|---|---|---|
| 225 | CsBi₄Te₆ : Sbl₃ (0,05%) | 3,5-10⁻³ |
| 300 | (Sb₂Te₃)₇₂Bi₂Te₃)₂₅(Sb₂Se₃)₃ | 3,4-10⁻³ |
| 500 | Tl₉BiTe₆ | 2,3-10⁻³ |
| 700 | GeTe₁₋ₓ(AgSbTe₂)ₓ | 3,0-10⁻³ |
| 1200 | Si_{0,85}Ge_{0,15} : B | 6,7-10⁻⁴ |

**Tabelle 1.2: die n-Typ Verbindungen mit den besten thermoelektrischen Eigenschaften.**

| T [K] | Verbindung n-Typ | Z [1/K] |
|---|---|---|
| 80 | Bi_{0,85}Sb_{0,15} | 6,5-10⁻³ |
| 300 | ((Sb₂Te₃)₅Bi₂Te₃)₉₀(Sb₂ Se₃)₅ | 3,2-10⁻³ |
| 450 | Bi₂Te_{2,7}Se_{0,3} | 2,8-10⁻³ |
| 800 | Pb_{0,75}Sn_{0,25}Se | >1,25-10⁻³ |
| 1200 | Si_{0,85}Ge_{0,15} : P | 8,3-10⁻⁴ |

Ein als Thermogenerator betriebenes Thermoelement besteht üblicherweise aus zwei dünnen wärmeleitenden, insbesondere keramischen Platten zwischen denen abwechselnd kleine Quader aus unterschiedlich leitendem Material, insbesondere Halbleitermaterial, eingelötet sind. Jeweils zwei unterschiedliche Quader sind so miteinander verbunden, dass sie eine Reihenschaltung ergeben. Eine der beiden Platten nimmt den einfließenden Wärmestrom auf (nachfolgend auch als heiße Seite des Thermoelementes bezeichnet), während die andere Platte den ausfließenden Wärmestrom abgibt(nachfolgend auch als kalte Seite des Thermoelementes bezeichnet).

Neben den herkömmlichen zwischen Platten angeordneten Thermoelementen können insbesondere auch Dünnschicht-Thermoelemente zum Einsatz gelangen, wie sie beispielsweise aus der DE 101 22 679 A1 bekannt sind. Auch Dünnschicht-Thermoelement weisen eine heiße und kalte Seite auf.

Die direkte Wandlung von Wärme in elektrische Energie ist mit den bekannten thermoelektrischen Generatoren möglich. In dem statt Metallen Halbleitermaterialien zum Einsatz gelangen, lässt sich die Effizienz gegenüber herkömmlichen Thermoelementen wesentlich steigern. Heute verfügbare Thermogeneratoren haben dennoch nur einen verhältnismäßig geringen Wirkungsgrad; er beträgt nur ein Bruchteil (ca. 17 %) des Carnot-Wirkungsgrades.

Ferner ist aus der DE 195 37 121 A1 eine Vorrichtung zur Gewinnung elektrischer Energie aus Sonnenstrahlung bekannt, wobei abweichend zu herkömmlichen Photovoltaikanlagen die Sonnenstrahlung nicht direkt genutzt wird, sondern die Strahlung in Wärme umgesetzt wird, welche dann an einem anderen Ort in Verbindung mit einer Wärmesenke durch Peltierelemente in elektrische Energie umgesetzt wird. Hierzu weist die Vorrichtung einen Kollektor zur Übertragung der Energie der Sonnenstrahlung auf ein erstes Wärmeträgermedium auf, sowie entfernt von dem Kollektor einen Wärmetauscher zur Übertragung der Wärme von dem ersten Wärmeträgermedium auf die Warmseite der Peltierelemente, deren Kaltseite mit einer Wärmesenke verbunden ist.

Aus der US 6,857,425 B2 ist ein thermischer Solar-Kollektor bekannt, der eine Kollektorplatte und eine der Sonneneinstrahlung abgewandet erste Platte aufweist sowie eine zwischen den beiden Platten angeordnete, beidseitig isolierte Stützplatte, die einen oberen Kanal und einen unteren Kanal für ein Wärmeträgermedium ausbildet, das zwischen dem oberen und dem unteren Kanal im Kreislauf geführt wird. An einer der Stirnseiten des oberen und unteren Kanals befindet sich ein wärmeleitfähiges Mittel, an dem das Wärmeträgermedium entlang strömt. Das Mittel leitet die in dem oberen Kanal aufgenommne Wärme an eine Einheit thermoelektrischer Elemente, die aus der Wärme Elektrizität erzeugen. An der Einheit thermoelektrischer Elemente ist ein Wärmetauscher angeschlossen, der die Wärme von der Einheit abführt und damit deren Effizienz steigert. Die abgeführte Wärme kann beispielsweise zur Gebäudeheizung verwendet werden.

Ausgehend von den bekannten thermoelektrischen Generatoren liegt der Erfindung die Aufgabe zu Grunde, einen thermoelektrischen Generator zu schaffen, der effizient Wärme einer thermischen Solaranlage zur Stromerzeugung nutzt.

Die Lösung dieser Aufgabe basiert auf dem Gedanken, den thermoelektrischen Generator als Baueinheit mit einem Kollektor für eine thermische Solaranlage auszuführen und das den Kollektor durchströmende Wärmeträgermedium zumindest zeitweilig mittels eines Wärmetauschers auch dem thermoelektrischen Generator zuzuführen. Hierdurch wird es möglich, eine in Folge der Sonneneinstrahlung in dem Kollektor erzeugte überschüssige Wärme, insbesondere bei sehr hohen Außentemperaturen, in dem thermoelektrischen Generator zur Stromerzeugung zu nutzen. Durch die gleichzeitige Erzeugung elektrischer und thermischer Energie wird die Effizienz des thermoelektrischen Generators bei starker Sonneneinstrahlung gesteigert.

Als thermische Solaranlage werden Solaranlagen bezeichnet, die Wärme aus der Sonneneinstrahlung nutzbar machen (Solarthermie). Bei der Wärmegewinnung wird der Absorber eines thermischen Kollektors durch die Sonnenenergie erhitzt. Durch den Kollektor strömt das Wärmeträgermedium, das die Wärme aufnimmt. Eine Pumpe fördert das Wärmeträgermedium in einem Solarkreislauf, über den die Wärme vom Kollektor in eine Wärmesenke, insbesondere den Solarwärmespeicher verbracht wird; der Solarwärmespeicher, nimmt Wärme auf und speichert sie.

Der Kollektor ist der Teil der Solaranlage, der die Wärme der Sonne aufnimmt und die absorbierte Wärme möglichst verlustfrei auf das Wärmeträgermedium im Solarkreislauf überträgt. Die wichtigste bautechnische Unterscheidung bei Kollektoren ist die zwischen Flachkollektoren und Röhrenkollektoren. Technisch unterscheiden sich die Flach- und Röhrenkollektoren durch die Isolierung des Absorbers. Die Isolationswirkung wird bei Vakuumröhrenkollektoren durch ein Vakuum in einer Glasröhre erreicht, welches einen Wärmetransport durch Konvektion vollständig unterbindet. Flachkollektoren nutzen herkömmliche Isoliermaterialien, zum Beispiel Mineralwolle oder Polyurethan-Schaum. Diese Isolierung ist weniger effizient als ein Vakuum, daher werden größere Kollektorflächen benötigt um vergleichbare Leistungswerte zu erreichen. Heutige Hochleistungs-Flachkollektoren arbeiten mit einem Kupferabsorber. Da Flachkollektoren jedoch deutlich preisgünstiger und damit in der Regel wirtschaftlicher sind als Vakuumröhrenkollektoren, wird in der Haustechnik überwiegend dieser Bautyp eingesetzt.

Von herkömmlichen Brauchwassertanks unterscheiden sich Solarwärmespeicher vor allem durch eine sehr starke Isolierung, eine hohe und schlanke Bauform des Wasserbehälters, die die Entwicklung unterschiedlicher Temperaturschichten erlaubt (oben heißes Wasser, unten kühles Wasser), sowie einen tief angebrachten, großflächigen Wärmeüberträger für die Übertragung der Wärme aus dem Solarkreislauf.

Sobald die Temperatur im Kollektor um eine festgelegte Temperaturdifferenz über der Temperatur am Solarwärmeüberträger liegt, wird von einer Steueranlage die Pumpe gestartet und die Wärme in den Solarwärmespeicher transportiert; sobald die Temperaturdifferenz zwischen Kollektor und Speicher den Grenzwert unterschreitet, wird die Anlage gestoppt.

Handelsübliche Kollektoren können 60 bis 70 Prozent der auf die Kollektorfläche auftreffenden Sonnenenergie in nutzbare Wärme umwandeln. In diesen Kollektoren wird meist ein Wasser-Propylenglykol-Gemisch (Verhältnis 60:40) als Wärmeträgermedium verwendet. Durch den Zusatz von 40 Prozent Propylenglykol wird ein Frostschutz bis -23 °C, darunter ein Gefrieren ohne Frostsprengung sowie eine Siedetemperatur, die je nach Druck 150 °C und mehr betragen kann, erreicht. Bei höheren Temperaturen gehen viele Kollektoren in Stillstand und liefern keine Energie mehr. Im Stillstand der Anlage besteht die Gefahr der Überhitzung und damit der Beschädigung der thermischen Solaranlage. Insbesondere die überschüssige Wärme bei höheren Temperaturen kann mit dem erfindungsgemäßen thermoelektrischen Generator genutzt und infolge dessen ein ineffizienter Stillstand der Anlage vermieden werden.

Im einzelnen wird die Aufgabe bei einem thermoelektrische Generator der eingangs erwähnten Art dadurch gelöst, dass an der heißen Seite ein Wärmetauscher für ein Wärmeträgermedium angeordnet ist, der flächig mit der passiven Rückseite eines von dem Wärmeträgermedium durchflossenen Kollektors für eine thermische Solaranlage verbunden ist, dass sich zwischen dem Kollektor und dem Wärmetauscher eine wärmedämmende Zwischenschicht befindet und dass in mindestens einer Schaltstellung einer Ventilsteuerung der Durchfluss des Wärmeträgermediums durch den Wärmtauscher unterbunden ist.

Die Kopplung des elektrischen Thermogenerators mit dem Kollektor einer thermischen Solaranlage ermöglicht es, die ungenutzte Wärme des Kollektors zur Energieerzeugung in dem Thermogenerator zu verwenden, insbesondere im Leerlauf des Kollektors.

Die zwischen dem Kollektor und dem Wärmetauscher angeordnete wärmedämmende Schicht verringert den Austausch von Wärmeenergie und verhindert weitgehend, dass dem Kollektor in der Leistungsphase, wenn der maximale Wärmestrom einer Wärmesenke in dem Solarkreislauf zugeführt werden soll, Wärme entzogen und an den Thermogenerator abgegeben wird. Die wärmedämmende Schicht besteht vorzugsweise aus Dämmstoff, insbesondere geschäumten Kunststoffen oder Mineralwolle.

Der Begriff Kollektor im Sinne der Erfindung umfasst eine Anordnung aus einem oder mehreren Sonnenkollektoren (z.B. Flachkollektoren und Röhrenkollektoren), die hintereinander und/oder parallel zueinander geschaltet sein können.

Der Kollektor ist über einen Solarkreislauf mit der Wärmesenke verbunden. Als Wärmesenke kommen insbesondere Wärmespeicher in Betracht, um die von dem Kollektor aufgenommene Wärme unabhängig von der aktuellen Sonneneinstrahlung nutzen zu können. Denkbar ist es jedoch auch, die von den Kollektoren aufgenommene Wärme über den Solarkreislauf unmittelbar einem als Wärmesenke wirkenden Verbraucher zuzuführen.

Die den einfließenden Wärmestrom aufnehmende heiße Seite des Thermogenerators liegt unmittelbar an dem Wärmetauscher vollflächig an, um den Wirkungsgrad weiter zu verbessern.

Um die für die Wärmeabgabe des Thermogenerators zur Verfügung stehende Fläche auf dessen kalter Seite zu vergrößern, kann der Thermogenerator einen Kühlkörper, insbesondere mit einer Rippenstruktur aufweisen. Die Rippen der Rippenstruktur erstrecken sich von der kalten Seite vorzugsweise in senkrechter Richtung. Durch die infolge der Rippen verbesserte Wärmeabfuhr wird der Wirkungsgrad des Thermogenerators verbessert.

Zur Auskopplung überschüssiger Wärme aus dem Kollektor ist dieser mittels der Ventilsteuerung zeitweilig mit dem Wärmetauscher verbindbar, der an der heißen Seite des Thermoelementes angeordnet ist. Das Wärmeträgermedium durchfließt zunächst den Kollektor und anschließend den Wärmetauscher, der die überschüssige Wärme in die heiße Seite des Thermogenerators einkoppelt.

Damit der der Kollektor und der Wärmetauscher von dem Wärmeträgermedium durchflossen werden können, weist der Kollektor einen Vorlaufanschluss und einen Rücklaufanschluss und der Wärmetauscher einen Einlassanschluss und einen Auslassanschluss auf, wobei die mindestens ein Ventil, vorzugsweise ein Mehrwegeventil, umfassende Ventilsteuerung einen Durchfluss des von dem Kollektor kommenden Wärmeträgermediums durch den Wärmetauscher ermöglicht oder unterbindet, indem das Ventil, insbesondere Mehrwegeventil, einen Durchflussweg von dem Vorlaufanschluss des Kollektors zum Einlassanschluss des Wärmetauschers freigibt oder unterbindet. Der Durchflussweg umfasst vorzugsweise Verrohrungen oder Schlauchverbindungen zwischen dem Vorlaufanschluss des Kollektors und dem Einlassanschluss des Wärmetauschers sowie den Anschlüssen des Ventils. Alternativ sind die den Durchflussweg zeitweilig freigebenden Anschlüsse des Ventils unmittelbar mit dem Vorlaufanschluss des Kollektors und dem Einlassanschluss des Wärmetauschers verbunden.

Um wahlweise den Kollektor mit dem Wärmespeicher in dem Solarkreislauf oder dem Wärmetauscher an der heißen Seite des Thermogenerators zu verbinden, ist vorzugsweise mindestens ein 3/2 - Wegeventil in den Vorlauf geschaltet, wobei in einer ersten Schaltstellung des 3/2 - Wegeventils dessen Anschlüsse den Durchflussweg von dem Kollektor zum Wärmespeicher und in einer zweiten Schaltstellung des 3/2-Wegeventils dessen Anschlüsse den Durchflussweg von dem Kollektor zum Wärmetauscher frei geben.

Die Freigabe des Durchflussweges von dem Kollektor zum Wärmetauscher des Thermogenerators erfolgt insbesondere bei vollständig aufgeheiztem Wärmespeicher und im Leerlauf der Solaranlage, um eine Überhitzung und damit Beschädigung des Kollektors sowie anderer Teile der thermischen Solaranlage zu verhindern. Insbesondere im Leerlauf wird der gesamte Wärmestrom von dem Kollektor zu dem Wärmetauscher geleitet und in dem Thermogenerator teilweise in elektrische Energie gewandelt. Während der Aufheizung des Wärmespeichers wird vorzugsweise keine Wärmeenergie zum Thermogenerator geführt.

Die Ventile der Ventilsteuerung können von Hand betätigt werden. Vorzugsweise handelt es sich jedoch um elektrische betätigte Mehrwege-Ventile oder Stetig-Ventile, die von einer Steuerung betätig werden, die aufgrund ihrer Messfühler einen Leerlauf der thermischen Solaranlage bzw. einen Wärmeüberschuss im Kollektor bzw. Solarkreislauf erkennt und in Folge dessen den Schaltbefehl für die Ventile auslöst. Für einen komplexeren Hybrid-Betrieb verzweigt die Steuerung über die Stetig-Ventile das Wärmeträgermedium bedarfsgerecht auf die Wärmesenke einerseits und den Wärmetauscher des Thermogenerator andererseits unter Berücksichtigung des Wärmeabflusses aus dem Wärmespeicher sowie der Intensität und Dauer der Sonneneinstrahlung auf den Kollektor.

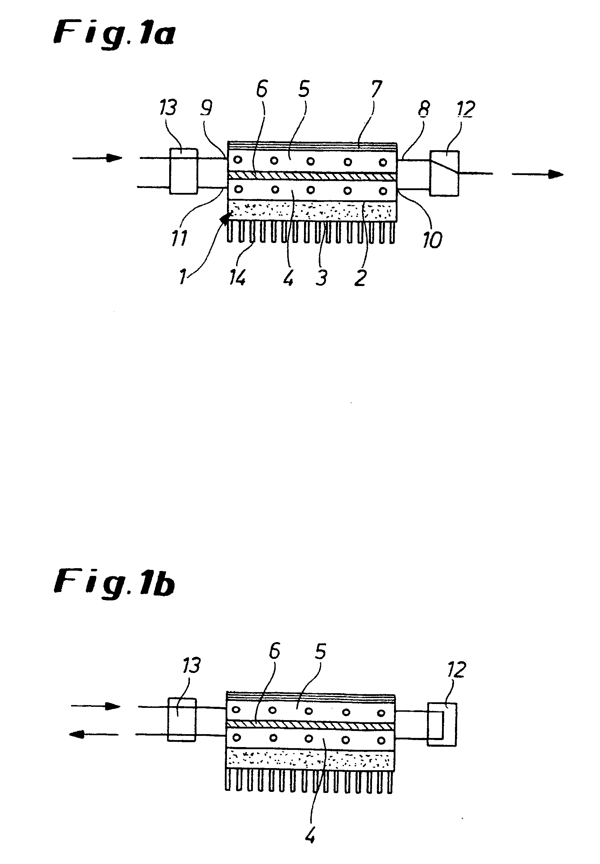

Nachfolgend wird die Erfindung anhand von Ausführungsbeispielen näher erläutert. Es zeigen
- **Figur 1 a**: ein Ausführungsbeispiel eines erfindungsgemäßen Thermogenerators in einem ersten Betriebsmodus
- **Figur 1 b**: der Thermogenerator nach Figur 1 a in einem zwei- ten Betriebsmodus sowie
- **Figur 2**: ein in eine thermische Solaranlage eingebundener Thermogenerator.

Figur 1a zeigt einen erfindungsgemäßen Thermogenerator (1) umfassend mehrere elektrisch miteinander verbundene Thermopaare, die zwischen einer einen einfließenden Wärmestrom aufnehmenden heißen Seite (2) und einer davon im Abstand angeordneten kalten Seite (3) angeordnet sind. An der heißen Seite (2) ist ein Wärmetauscher (4), insbesondere in Form eines Röhrenwärmetauschers, angeordnet. Der Wärmetauscher (4) ist flächig mit der passiven Rückseite eines Kollektors (5) einer thermischen Solaranlage verbunden. Zwischen dem Kollektor (5) und dem Wärmetauscher (4) ist zur thermischen Entkopplung eine wärmedämmende Zwischenschicht (6) angeordnet.

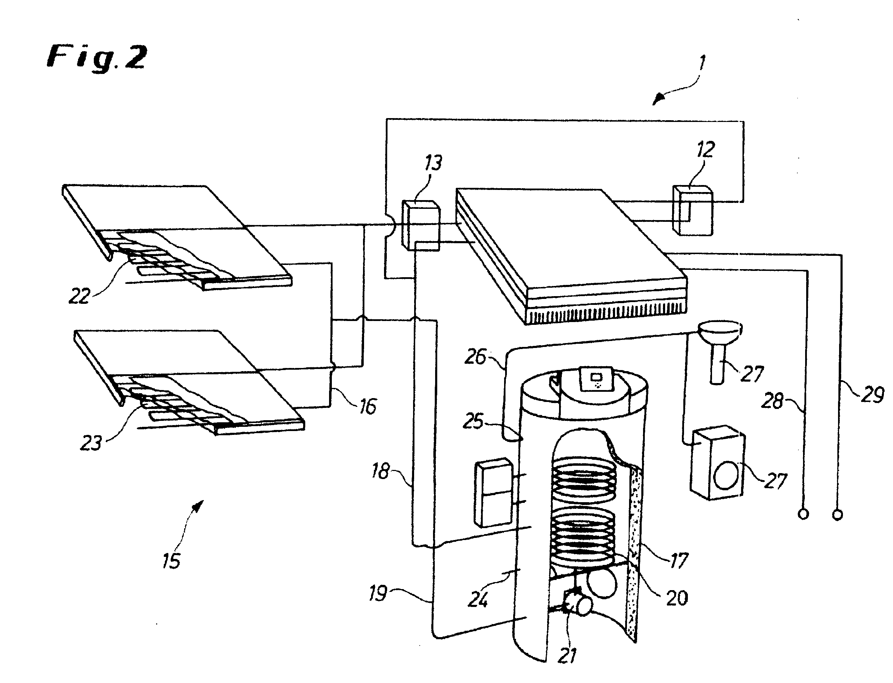

Bei dem Kollektor (5) handelt es sich in dem dargestellten Ausführungsbeispiel um einen Röhrenkollektor, der insbesondere Teil einer Solaranlage ist, wie sie exemplarisch in Figur 2 dargestellt und weiter unten erläutert wird. Bei der Wärmegewinnung wird der oberhalb des Kollektors (5) angeordnete Absorber (7) durch Sonnenenergie erhitzt. Durch den Kollektor (5) strömt ein Wärmeträgermedium, das die Wärme aufnimmt. Mittels einer Pumpe wird das Wärmeträgermedium in einem Solarkreislauf gefördert und einer Wärmesenke, insbesondere einem Solarwärmespeicher, zugeführt, der die Wärme aufnimmt und speichert.

Der Kollektor (5) hat einen Vorlaufanschluss (8), an dem eine Verrohrung für das in Folge der Sonneneinstrahlung erwärmte Wärmeträgermedium angeschlossen ist. An der gegenüberliegenden Seite findet sich der Rücklaufanschluss (9) des Kollektors (5). Der Wärmetauscher (4) besitzt ebenfalls zwei Anschlüsse, nämlich einen Einlassanschluss (10) und einen Auslassanschluss (11). Schließlich weist der Thermogenerator eine im dargestellten Ausführungsbeispiel zwei Mehrwege-Ventile (12, 13) umfassende Ventilsteuerung auf. Bei dem MehrwegeVentil (12) handelt es sich um einen Drei/Zwei-Wegeventil. Bei dem Wege-Ventil (13) handelt es sich um ein Vier/ZweiWegeventil.

In der in Figur 1a dargestellte Schaltstellung der beiden Wegeventile (12, 13) ist der Durchfluss des Wärmeträgermediums durch den Kollektor (5) freigegeben und durch den Wärmetauscher (4) gesperrt. Sofern der Rücklaufanschluss (9) über das Ventil (13) beispielsweise mit einem weiteren thermischen Kollektor einer Solaranlage verbunden ist, wird die dort aufgenommene Wärme sowie die von dem Kollektor (5) aufgenommene Wärme vollständig über das Wegeventil (12) einer Wärmesenke, insbesondere einem Wärmespeicher einer Solaranlage, zugeführt. Dieser in Figur 1a dargestellte Betriebsmodus wird gewählt, wenn die Temperatur in dem Kollektor (5) sowie dem vorgeschalteten thermischen Kollektor über der Temperatur im Wärmespeicher liegt und dieser noch nicht seine volle Wärmekapazität aufweist.

Weist indes der Wärmespeicher seine volle Wärmekapazität auf oder wird an der dem Kollektor (5) nachgeordneten Wärmesenke keine Wärme benötigt, geht der Thermogenerator (1) in den in Figur 1b dargestellten Betriebsmodus. Das bereits aufgewärmte, von dem thermischen Kollektor kommende Wärmeträgermedium wird über den Rücklaufanschluss (9) durch den Kollektor (5) und das Wegeventil (12) in den Wärmetauscher (4) geleitet, der die überschüssige Wärme in die heiße Seite (2) des Thermogenerators (1) einkoppelt, wo die Wärme in elektrische Energie gewandelt wird. Zur Steigerung des Wirkungsgrades bei dieser Energiewandlung ist an der kalten Seite (3) des Thermogenerators (1) ein Kühlkörper (14) angeordnet. Der Auslassanschluss (11) des Wärmetauschers (4) führt zum Solarwärmespeicher.

Durch den erfindungsgemäßen Thermogenerator (1) kann insbesondere durch die Abkühlung des Wärmeträgermediums beim Durchlauf durch den Wärmetauscher (4) ein unerwünschter Stillstand der Solaranlage vermieden werden und gleichzeitig die überschüssige, zum Stillstand des thermischen Kollektors führende Energie in elektrische Energie gewandelt werden.

Figur 2 zeigt eine thermische Solaranlage (15) mit einem erfindungsgemäßen Thermogenerator (1). Der Thermogenerator ist über einen Solarkreislauf (16) mit einem Wärmespeicher (17) verbunden. Der Solarkreislauf (16) besteht aus einem Vorlauf (18), einem Rücklauf (19) sowie einem in dem Wärmespeicher (17) angeordneten Rohrwärmetauscher (20), der der Übertragung der Wärme aus dem Solarkreislauf (16) auf das Wasser im Wärmespeicher (17) dient. Ferner befindet sich am Ende des Rücklaufs (19) eine Pumpe (21), die das Wärmeträgermedium in dem Solarkreislauf (16) mit den beiden thermischen Kollektoren (22, 23) sowie dem Kollektor (5) und ggf. dem Wärmetauscher (4) zirkulieren lässt.

Der Wärmespeicher (17) ist als hohlzylindrischer Solartank ausgeführt. Als Speichermedium dient Wasser, das über einen Zulauf (24) dem Wärmespeicher (17) zugeführt wird. Die hohe und schlanke Bauform des Wärmespeichers (17) erlaubt die Ausbildung unterschiedlicher Temperaturschichten. Im oberen Teil des Wärmespeichers (17) befindet sich heißes, unten kühleres Wasser. Die Entnahmestelle im oberen Behälterteil des Wärmespeichers (17) ist über Rohrleitungen (26) mit den Warmwasserverbrauchern (27) verbunden.

Die in Figur 2 ebenfalls dargestellten Mehrwegeventile (12, 13) sind, wie in den Figuren 1a, 1b dargestellt, geschaltet. Es ist jedoch auch möglich, nach vollständiger Aufheizung des Wärmespeichers (17) das Wärmeträgermedium ausschließlich in dem durch die thermischen Kollektoren (22, 23) sowie den Kollektor (5) und den Wärmetauscher (4) gebildeten Kreislauf zirkulieren zu lassen. In diesem Fall bedarf es einer zusätzlichen Umwälzpumpe. Für diesen reinen Stromerzeugungsbetrieb des Thermogenerators (1) wird die Wärme der thermischen Kollektoren (22, 23), die ansonsten zur Aufheizung des Wärmespeichers (17) verwendet wird, ausschließlich in elektrische Energie umgewandelt.

Der Thermogenerator (1) selbst ist über zwei nicht dargestellte Kontaktstellen mit elektrischen Leitungen (28, 29) verbunden, über die die elektrische Energie von dem thermoelektrischen Generator (1) abgeführt wird.

### Bezugszeichenliste

| Nr. | Bezeichnung |
|---|---|
| 1. | Thermogenerator |
| 2. | heiße Seite |
| 3. | kalte Seite |
| 4. | Wärmetauscher |
| 5. | Kollektor |
| 6. | Zwischenschicht |
| 7. | Absorber |
| 8. | Vorlaufanschluss Kollektor |
| 9. | Rücklaufanschluss Kollektor |
| 10. | Einlassanschluss Wärmetauscher |
| 11. | Auslassanschluss Wärmetauscher |
| 12. | Mehrwegeventil |
| 13. | Mehrwegeventil |
| 14. | Kühlkörper |
| 15. | thermische Solaranlage |
| 16. | Solarkreislauf |
| 17. | Wärmespeicher |
| 18. | Vorlauf |
| 19. | Rücklauf |
| 20. | Rohrwärmetauscher |
| 21. | Pumpe |
| 22. | thermischer Kollektor |
| 23. | thermischer Kollektor |
| 24. | Zulauf |
| 25. | Entnahmestelle |
| 26. | Rohrleitung |
| 27. | Warmwasserverbraucher |
| 28. | elektrische Leitung |
| 29. | elektrische Leitung |

## Patentansprüche

1. Thermogenerator mit mehreren elektrisch miteinander verbundenen Thermopaaren, die zwischen einer einen einfließenden Wärmestrom aufnehmenden heißen Seite und einer davon im Abstand angeordneten kalten Seite angeordnet sind, **dadurch gekennzeichnet, dass** an der heißen Seite (2) ein Wärmetauscher (4) für den Durchfluss eines Wärmeträgermediums angeordnet ist, der flächig mit der passiven Rückseite eines von dem Wärmeträgermediums durchflossenen Kollektors (5) für eine thermischen Solaranlage (15) verbunden ist, dass sich zwischen dem Kollektor (5) und dem Wärmetauscher (4) eine wärmedämmende Zwischenschicht (6) befindet und dass in mindestens einer Schaltstellung einer Ventilsteuerung (12,13) der Durchfluss des Wärmeträgermediums durch den Wärmetauscher (4) unterbunden ist.

2. Thermogenerator nach Anspruch 1, **dadurch gekennzeichnet, dass** der Wärmetauscher (4) plattenförmig ist.

3. Thermogenerator nach Anspruch 1 oder 2, **dadurch gekennzeichnet, dass** der Thermogenerator (1) mindestens ein Dünnschicht-Thermoelement aufweist.

4. Thermogenerator nach einem der Ansprüche 1 bis 3, **dadurch gekennzeichnet, dass** der Wärmetauscher (4) ein Plattenwärmetauscher oder ein Rohrwärmetauscher ist.

5. Thermogenerator nach einem der Ansprüche 1 bis 4, **dadurch gekennzeichnet, dass** an der kalten Seite (3) des Thermogenerators (1) ein Kühlkörper (14) angeordnet ist.

6. Thermogenerator nach einem der Ansprüche 1 bis 5, **dadurch gekennzeichnet, dass** die Ventilsteuerung mindestens ein Mehrwegeventil (12,13) umfasst.

7. Thermogenerator nach Anspruch 6, **dadurch gekennzeichnet, dass** in mindestens einer Schaltstellung des mindestens einen Mehrwegeventils (12) der Kollektor (5) zeitweilig mit dem Wärmetauscher (4) verbindbar ist.

8. Thermische Solaranlage mit einem Thermogenerator nach Anspruch 6 oder 7, **dadurch gekennzeichnet, dass** der Kollektor (5) über einen ein Wärmeträgermedium enthaltenden Solarkreislauf (16) mit einer Wärmesenke (17) verbunden ist und dieser Solarkreislauf (16) einen Vorlauf (18) und einen Rücklauf (19) zwischen dem Kollektor (5) und der Wärmesenke (17) aufweist und zumindest ein Mehrwegeventil (12) der Ventilsteuerung in den Vorlauf (18) geschaltet ist, wobei in einer ersten Schaltstellung des Mehrwegeventils (12) dessen Anschlüsse den Durchflussweg von dem Kollektor (5) zur Wärmesenke (17) und in einer zweiten Schaltstellung des Mehrwegeventils (12) dessen Anschlüsse den Durchflussweg von dem Kollektor (5) zum Wärmetauscher (4) freigeben.

## Claims

1. A thermogenerator comprising a plurality of electrically interconnected thermocouples which are located between a hot side which receives an inflowing thermal flow and a cold side located at a distance wherefrom, **characterised in that** a heat exchanger (4) for the flow of a heat-transfer medium is arranged on the hot side (2) which is connected extensively to the passive rear side of a collector (5) for a thermal solar system (15), through which the heat transfer medium flows, that a heat-insulating intermediate layer (6) is arranged between the collector (5) and the heat exchanger (4) and that in at least one switching position of a valve control system (12, 13), the flow of the heat-transfer medium through the heat exchanger (4) is prevented.

2. The Thermogenerator system according to claim 1, **characterised in that** the heat exchanger (4) is plateshaped.

3. The thermogenerator system according to claim 1 or 2, **characterised in that** the thermogenerator (1) comprises at least one thin-film thermocouple.

4. The thermogenerator according to any one of claims 1 to 3, **characterised in that** the heat exchanger (4) is a plate-type heat exchanger or a tubular heat exchanger.

5. The thermogenerator according to any one of claims 1 to 4, **characterised in that** a cooling element (14) is arranged on the cold side (3) of the thermogenerator (1).

6. The thermogenerator according to any one of claims 1 to 5, **characterised in that** the valve control system comprises at least one multi-way valve (12, 13).

7. The thermogenerator according to claim 6, **characterised in that** in at least one switching position of the at least one multi-way valve (12), the collector (5) can be connected temporarily to the heat exchanger (4).

8. A thermal solar system comprising a thermogenerator according to claim 6 or 7, **characterised in that** the collector (5) is connected to a heat sink (17) via a solar circuit (16) containing a heat-transfer medium and this solar circuit (16) comprises a forward-flow line (18) and a return-flow line (19) between the collector (5) and the heat sink (17), and at least one multi-way valve (12) of the valve control system is connected in the forward-flow line (18), wherein in a first switching position of the multi-way valve (12), its connections open the flow path from the collector (5) to the heat sink (17) and in a second switching position of the multi-way valve (12), its connections open the flow path from the collector (5) to the heat exchanger (4).

## Revendications

1. Thermogénérateur comprenant plusieurs thermocouples reliés électriquement les uns aux autres, qui sont disposés entre un côté chaud recevant un flux de chaleur entrant et un côté froid disposé distance du premier côté, **caractérisé en ce qu'**un échangeur de chaleur (4) est disposé sur le côté chaud (2) pour le passage d'un agent caloporteur, lequel est relié à plat au côté arrière passif d'un collecteur (5) traversé par l'agent caloporteur pour une installation solaire thermique (15), **en ce qu'**une couche intermédiaire (6) thermo-isolante se trouve entre le collecteur (5) et l'échangeur de chaleur (4) et **en ce que** l'écoulement de l'agent caloporteur dans l'échangeur de chaleur (4) est interdit dans au moins une position de commutation d'une commande de soupape (12, 13).

2. Thermogénérateur selon la revendication 1, **caractérisé en ce que** l'échangeur de chaleur (4) est en forme de plaque.

3. Thermogénérateur selon la revendication 1 ou 2, **caractérisé en ce que** le thermogénérateur (1) présente au moins un thermocouple à couche mince.

4. Thermogénérateur selon l'une quelconque des revendications 1 à 3, **caractérisé en ce que** l'échangeur de chaleur (4) est un échangeur de chaleur plaques ou un échangeur de chaleur tubulaire.

5. Thermogénérateur selon l'une quelconque des revendications 1 à 4, **caractérisé en ce qu'**un corps réfrigérant (14) est disposé sur le côté froid (3) du thermogénérateur (1).

6. Thermogénérateur selon l'une quelconque des revendications 1 à 5, **caractérisé en ce que** la commande de soupape comprend au moins une soupape à plusieurs voies (12, 13).

7. Thermogénérateur selon la revendication 6, **caractérisé en ce que** le collecteur (5) peut être relié temporairement à l'échangeur de chaleur (4) dans au moins une position de commutation de la au moins une soupape à plusieurs voies (12).

8. Installation solaire thermique avec un thermogénérateur selon la revendication 6 ou 7, **caractérisée en ce que** le collecteur (5) est relié au moyen d'un circuit solaire (16) contenant un agent caloporteur à une source de chaleur (17) et ce circuit solaire (16) présente un aller (18) et un retour (19) entre le collecteur (5) et la source de chaleur (17) et au moins une soupape à plusieurs voies (12) de la commande de soupape est branchée sur le circuit aller (18), sachant que, lorsque la soupape à plusieurs voies (12) est dans une première position de commutation, ses branchements libèrent la voie d'écoulement allant du collecteur (5) à la source de chaleur (17) et, lorsque la soupape à plusieurs voies (12) est dans une seconde position de commutation, ses branchements libèrent la voie d'écoulement allant du collecteur (5) à l'échangeur de chaleur (4).
